Europäisches Patentamt

**European Patent Office**

Office européen des brevets

(11) Numéro de publication: **0 205 380**
**A1**

(12) **DEMANDE DE BREVET EUROPEEN**

(21) Numéro de dépôt: **86401178.8**

(22) Date de dépôt: **03.06.86**

(51) Int. Cl.⁴: **H 01 G 1/035**
**H 01 G 4/30**

(30) Priorité: **03.06.85 FR 8508330**

(43) Date de publication de la demande:
**17.12.86 Bulletin 86/51**

(84) Etats contractants désignés:
**AT BE CH DE FR GB IT LI NL SE**

(71) Demandeur: **EUROFARAD-EFD**
**93 rue Oberkampf**
**F-75540 Paris Cédex11(FR)**

(72) Inventeur: **Dubuisson, Jacques**
**22, avenue Emile Zola**
**F-75015 Paris(FR)**

(74) Mandataire: **Martin, Jean-Jacques et al,**
**Cabinet REGIMBEAU 26, Avenue Kléber**
**F-75116 Paris(FR)**

(54) Composant céramique multicouche pour report direct sur un substrat.

(57) L'invention concerne un composant céramique multi-couche (C) pour report direct sur un substrat (1), comportant, dans un bloc céramique diélectrique, des métallisations conductrices (21-24, 31-34) disposées selon des motifs internes préétablis, destinés à être reliés à des pistes conductrices respectives (2, 3) formées sur le substrat.

Selon l'invention, les métallisations débordent, sans solution de continuité, de la face latérale du composant et retombent le long de celle-ci en direction du substrat, les différentes métallisations à réunir à une même piste étant superposées les unes aux autres, de manière à constituer des terminaisons latérales homogènes (20, 30), adjacentes aux faces latérales du bloc céramique, et destinées à être soudées aux pistes conductrices respectives du substrat.

FIG.1

EP 0 205 380 A1

Croydon Printing Company Ltd

COMPOSANT CERAMIQUE MULTICOUCHE POUR REPORT DIRECT SUR UN SUBSTRAT

La présente invention concerne les composants céramique multicouches pour report direct sur un substrat.

Les composants de ce type sont dépourvus de fils de connexion, et présentent des faces latérales métallisées destinées à se présenter perpendiculairement au substrat. Une fois le condensateur placé sur le substrat, il suffit de réaliser des points de soudure, par exemple par soudage à la vague, entre ces faces latérales et les pistes conductrices correspondantes du substrat pour établir simultanément la liaison électrique et la fixation mécanique du composant à son substrat.

La tenue aux cycles thermiques de ces composants est cependant limitée, du fait de la différence importante de coefficient de dilatation existant entre le condensateur (de l'ordre de 5 à $9.10^{-6}$ pour une céramique classique) et le substrat (la limite inférieure étant de l'ordre de 15 à $20.10^{-6}$ pour des substrats en verre époxy). Les contraintes dues aux dilatations différentielles lors des cycles thermiques produisent peu à peu des fissurations des soudures de liaison, qui empêchent d'utiliser de tels composants dans un environnement trop sévère.

L'invention propose de remédier à cet inconvénient, grâce à un composant dont la structure assure une élasticité suffisante permettant d'absorber les dilatations différentielles composant-substrat, même pour des écarts importants de température : le composant de l'invention est ainsi parfaitement adapté aux normes des matériels professionnels ou militaires, qui exigent une parfaite tenue en température pour des valeurs comprises entre -55°C et + 125°C, ou même -55°C et + 200°C.

A cet effet, il est proposé un composant céramique multicouche pour report direct sur un substrat, comportant, dans un bloc céramique diélectrique, des métallisations conductrices disposées selon des motifs internes préétablis, destinés à être reliés à des pistes conductrices respectives formées sur le substrat.

Selon l'invention, les métallisations débordent, sans solution de continuité, de la face latérale du composant et retombent le long de celle-ci en direction du substrat, les différentes métallisations à réunir à une même piste étant superposées les unes aux autres, de manière à constituer des terminaisons latérales homogènes, adjacentes aux faces latérales du bloc céramique, et destinées à être soudées aux pistes conductrices respectives du substrat.

De préférence, l'extrémité des métallisations présente un prolongement s'étendant, au voisinage du substrat, dans une direction sensiblement perpendiculaire à la face latérale du bloc céramique.

Grâce à l'homogénéité de l'ensemble et à l'élasticité du matériau des métallisations, le composant peut absorber sans difficulté les dilatations différentielles résultant des cycles thermiques.

De préférence, le composant comporte, sur sa face tournée vers le substrat, au moins deux surépaisseurs formant pied de lavage.

Avantageusement, les métallisations sont formées d'un alliage argent-palladium dans des proportions relatives comprises entre 40:60 et 70:30.

Le composant peut par exemple être un condensateur; dans ce cas les métallisations successives débouchent alternativement de part et d'autre du bloc céramique de manière à former deux séries d'électrodes élémentaires réunies en parallèle par les terminaisons latérales.

L'invention concerne également un procédé de fabrication d'un tel composant, comprenant les étapes suivantes :

a) empilage, sur un support de travail, d'au moins une feuille de céramique crue, coulée, comportant des lumières à l'emplacement des terminaisons latérales des composants individuels à réaliser, de manière à former des alvéoles dans le flan de céramique ;

b) sérigraphie d'un motif sur la feuille supérieure de l'empilement, l'encrage de cette sérigraphie étant réalisé de manière à obtenir un écoulement de l'encre le long des parois des alvéoles et au fond de ceux-ci ;

c) séchage de l'encre ;

d) répétition des étapes a) à c) autant de fois qu'il est prévu de niveaux de motifs pour le composant, les lumières de toutes les feuilles empilées étant identiques et superposées ;

e) mise en place d'une feuille de couverture, dépourvue de motif, comportant également des lumières identiques et superposées à celles des autres feuilles de l'empilement ;

f) compression de l'empilement ;

g) découpe des composants individuels ;

h) évaporation des solvants et des liants ;

i) frittage de la céramique ;

j) finition des terminaisons latérales par dépôt d'un métal de protection.

La compression peut être réalisée par un ensemble poinçon-matrice de forme complémentaire de la forme désirée ; elle peut également être réalisée par un ensemble formé d'un poinçon et d'une embase plane en résine souple, si l'épaisseur du composant est faible.

D'autres caractéristiques et avantages de l'invention apparaîtront à la lecture de la description détaillée ci-dessous d'un exemple de réalisation, en référence aux dessins annexés sur lesquels :

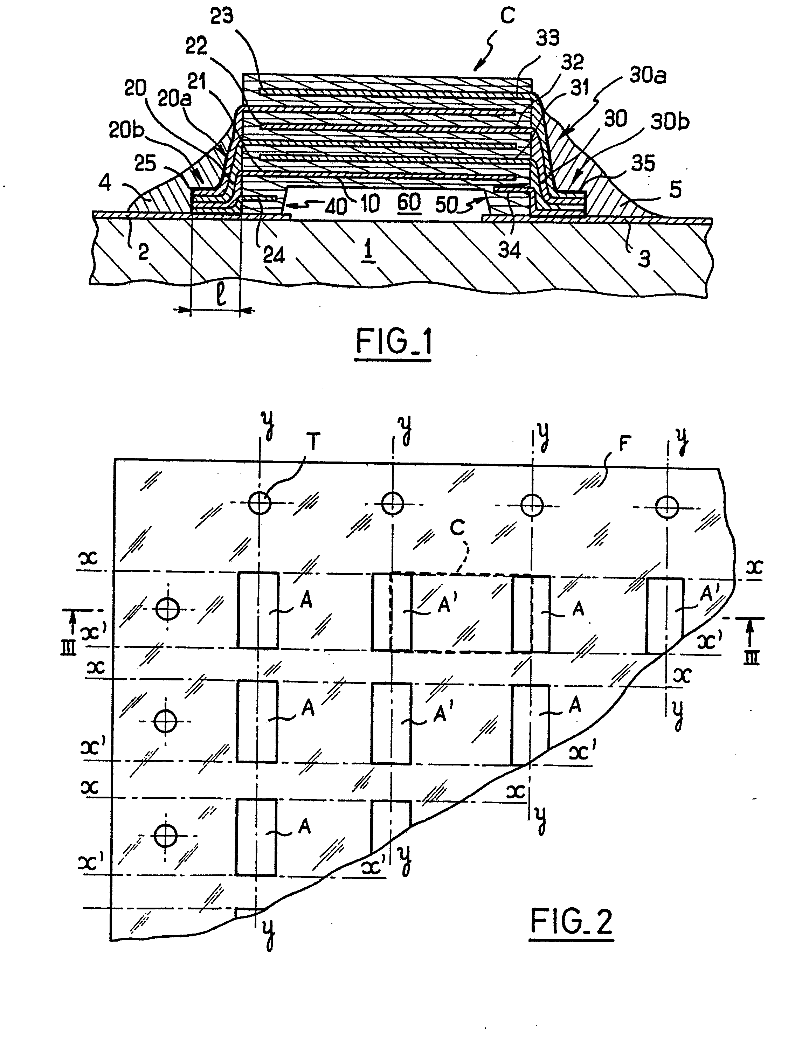

. la figure 1 montre une coupe d'un condensateur réalisé suivant les enseignements de l'invention, soudé sur son substrat,

. la figure 2 est une vue en plan d'une feuille de céramique utilisée pour la fabrication de ce composant,

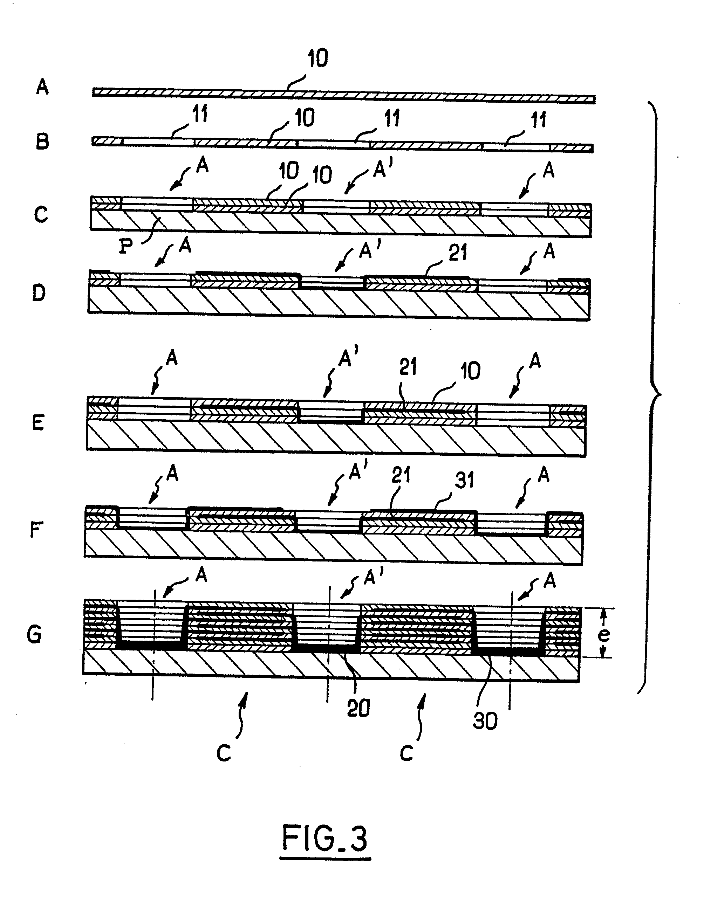

. la figure 3, correspondant à la coupe selon la ligne III-III de la figure 2, illustre les différentes étapes successives du procédé de fabrication.

Sur la figure 1, on a représenté un condensateur C soudé sur le substrat 1. Ce condensateur est constitué d'un empilement de feuilles de céramique diélectrique 10, empilement dans lequel sont prévus des motifs conducteurs formant armatures élémentaires, respectivement 21, 22, 23 et 31, 32, 33. Ces armatures sont réunies en parallèle par des terminaisons latérales 20, 30, réalisées sur les faces latérales du condensateur, et qui permettent sa liaison à des pistes conductrices 2, 3 du substrat au moyen de soudures 4, 5.

De façon caractéristique de l'invention, les terminaisons latérales 20, 30 sont formées par des prolongements des métallisations qui forment les armatures élémentaires : celles-ci débordent de la face latérale du bloc de céramique et retombent le long de celle-ci en direction du substrat (régions 20a, 30a).

5

Les différentes couches formées par les métallisations sont superposées les unes aux autres de manière à former un ensemble rigide, présentant toutefois une élasticité suffisante pour absorber les dilatations différentielles mentionnées plus haut.

De préférence, l'extrémité de ces différentes métallisations présente un prolongement 20b, 30b s'étendant, au voisinage du substrat, dans une direction sensiblement perpendiculaire à la face latérale du composant. Ces prolongements permettent une meilleure fixation du composant aux pistes conductrices 2, 3 ; la largeur $\ell$ de ces prolongements peut être par exemple de l'ordre de 500 μm.

Avantageusement, le condensateur est pourvu de pieds 40, 50 permettant le lavage de la région 60 située en dessous du condensateur. Ces pieds de lavage sont réalisés selon la technique décrite au FR-A-2 529 378, au nom de la Demanderesse, auquel on se reportera pour de plus amples détails, tant en ce qui concerne leur structure que les différents procédés de fabrication. Dans ce cas, le condensateur peut comporter des métallisations internes 24, 34 sans rôle électrique, mais qui contribuent cependant à la rigidité mécanique de l'ensemble.

On va maintenant décrire un procédé de fabrication d'un tel composant.

On prépare d'abord une feuille coulée de céramique crue F (illustrée figure 2), pourvue de trous repères T à sa périphérie.

Cette feuille 10 (figure 3 A) est ensuite poinçonnée de manière à former des lumières 11 (figure 3 B) à l'emplacement où se trouveront plus tard les terminaisons latérales des composants individuels à réaliser (on a représenté en tireté, sur la figure 2, le contour d'un composant C, qui sera individualisé après découpage dans une étape ultérieure du procédé).

On dépose ensuite une ou plusieurs de ces feuilles 10 sur une feuille de papier sans cendre P (c'est-à-dire un papier ne laissant aucun résidu après destruction à haute température), en utilisant les trous repères T pour aligner les différentes lumières : l'ensemble obtenu (figure 3 C) forme ainsi un certain nombres d'alvéoles A, A' à l'emplacement des lumières superposées, dont le fond est constitué par la feuille de papier P (cette feuille de papier ayant elle-même été préalablement encollée sur un cadre métallique, de manière classique).

On procède ensuite (figure 3 D) à la sérigraphie d'un premier niveau de métallisations, par exemple pour former les électrodes 21 du condensateur de la figure 1. Cette sérigraphie est réalisée de telle sorte que, lors de l'encrage, l'encre déborde le long des parois latérales de l'alvéole A' et se répande au fond de celui-ci, de manière à y former une couche continue.

L'encre est ensuite séchée, par exemple par exposition à un rayonnement infra-rouge.

On positionne ensuite (figure 3 E) une nouvelle couche de céramique crue poinçonnée, dont les lumières sont alignées avec les lumières des couches précédentes.

On procède ensuite à la sérigraphie d'un second niveau de métallisations (figure 3 F), par exemple pour réaliser les électrodes 31 du composant de la figure 1. Comme précédemment, on fait en sorte que l'encre se répande le long des parois d'un alvéole (dans cette étape, l'alvéole A et non plus l'alvéole A') et s'étale au fond de celui-ci.

On procède à nouveau à un séchage de l'encre, et on recouvre l'ensemble d'une nouvelle couche de céramique crue, poinçonnée de la même façon que les précédentes.

Les opérations précédentes (sérigraphie, séchage et couverture par une feuille de céramique) sont répétées autant de fois que l'on souhaite former de niveaux de métallisations.

Le résultat de ces étapes successives est illustré figure 3 G, où l'on retrouve la structure du composant de la figure 1 avec ses différentes électrodes alternées, une première série d'électrodes étant réunies ensemble par les couches successives d'encre superposées sur les parois et au fond de l'alvéole A, l'autre série d'armatures l'étant par les couches superposées sur les parois et au fond de l'alvéole A'.

Le flan ainsi obtenu est ensuite comprimé, à une pression de l'ordre de 300 bar, soit au moyen d'un ensemble poinçon-matrice de forme complémentaire de la forme désirée (dans le cas d'une épaisseur $e$ élevée, c'est-à-dire supérieure à 1 ou 1,5 mm), soit par un poinçon venant appuyer le bloc contre une embase plane en résine souple, silicone ou époxy (dans le cas d'un flan de faible épaisseur).

Le flan est ensuite extrait du cadre métallique par une nouvelle compression.

Les composants sont enfin individualisés par découpe du flan ainsi obtenu au moyen d'une lame chauffée à double biseau, selon les lignes xx et x'x' (figure 2), puis selon les lignes yy passant au milieu des alvéoles A et A'. Par cette dernière découpe, les couches métalliques déposées au fond des alvéoles vont constituer les terminaisons 20, 30 (figure 3 G) du composant.

On procède ensuite à une évaporation des solvants et des liants puis à un frittage de la céramique.

Après frittage, on procède à une finition des terminaisons par dépôt d'une couche de protection 25, 35 (figure 1).

Cette finition peut être opérée par exemple par nickelage, chimique ou galvanique, sur une épaisseur de l'ordre de 2 µm puis dépôt d'une couche de protection d'or.

Elle peut également être réalisée par étamage électrolytique ou au trempé des terminaisons du composant.

Les céramiques et les encres de métallisations utilisées peuvent être de tout type, y compris les céramiques destinées aux hyperfréquences.

On peut par exemple utiliser une céramique à base de titanate de baryum contenant environ 2 % d'oxyde de praséodyme, avec des métallisations en argent-palladium dans des proportions relatives 40:60.

On peut également utiliser une céramique à base de titanate de baryum et de titanate de bismuth dans une proportion de 10 à 15 % en poids, avec des métallisations également en argent-palladium dans une proportion relative 70:30.

Enfin, on notera que l'exemple détaillé, qui concerne la fabrication d'un condensateur, n'est pas limitatif, mais que l'invention s'applique à tout type de composants céramique multicouches comportant des métallisations internes avec ou sans rôle capacitif, par exemple à des supports de semiconducteur ou d'autres composants discrets permettant le report sur un substrat, comme cela est réalisé couramment dans
la technique des circuits hybrides.

REVENDICATIONS

1. Un composant céramique multicouche (C) pour report direct sur un substrat (1), comportant, dans un bloc céramique diélectrique, des métallisations conductrices (21-24, 31-34) disposées selon des motifs internes préétablis, destinés à être reliés à des pistes conductrices respectives (2, 3) formées sur le substrat, caractérisé en ce que les métallisations débordent, sans solution de continuité, de la face latérale du composant et retombent le long de celle-ci en direction du substrat, les différentes métallisations à réunir à une même piste étant superposées les unes aux autres, de manière à constituer des terminaisons latérales homogènes (20, 30), adjacentes aux faces latérales du bloc céramique, et destinées à être soudées aux pistes conductrices respectives du substrat.

2. Un composant selon la revendication 1, dans lequel l'extrémité des métallisations présente un prolongement (20b, 30b) s'étendant, au voisinage du substrat, dans une direction sensiblement perpendiculaire à la face latérale du bloc céramique.

3. Un composant selon la revendication 1, dans lequel le composant comporte, sur sa face tournée vers le substrat, au moins deux surépaisseurs (40, 50) formant pied de lavage.

4. Un composant selon la revendication 1, dans lequel les métallisations sont formées d'un alliage argent-palladium dans des proportions relatives comprises entre 40:60 et 70:30.

5. Un composant selon la revendication 1, dans lequel le composant est un condensateur, les métallisations successives débouchant alternativement de part et d'autre du bloc céramique de manière à former deux séries d'électrodes élémentaires réunies en parallèle par les terminaisons latérales.

6. Procédé de fabrication d'un composant selon l'une des revendications précédentes, caractérisé en ce qu'il comprend les étapes suivantes :

a) empilage, sur un support de travail, d'au moins une feuille de céramique crue, coulée, comportant des lumières à l'emplacement des terminaisons latérales des composants individuels à réaliser, de manière à former des alvéoles dans le flan de céramique ;

b) sérigraphie d'un motif sur la feuille supérieure de l'empilement, l'encrage de cette sérigraphie étant réalisé de manière à obtenir un écoulement de l'encre le long des parois des alvéoles et au fond de ceux-ci ;

c) séchage de l'encre ;

d) répétition des étapes a) à c) autant de fois qu'il est prévu de niveaux de motifs pour le composant, les lumières de toutes les feuilles empilées étant identiques et superposées ;

e) mise en place d'une feuille de couverture, dépourvue de motif, comportant également des lumières identiques et superposées à celles des autres feuilles de l'empilement ;

f) compression de l'empilement ;

g) découpe des composants individuels ;

h) évaporation des solvants et des liants ;

i) frittage de la céramique ;

j) finition des terminaisons latérales par dépôt d'un métal de protection.

7. Procédé de fabrication d'un composant selon la revendication 6, dans lequel la compression est réalisée par un ensemble poinçon-matrice de forme complémentaire de la forme désirée.

8. Procédé de fabrication d'un composant selon la revendication 6, dans lequel la compression est réalisée par un ensemble formé d'un poinçon et d'une embase plane en résine souple.

9. Procédé de fabrication d'un composant selon la revendication 6, dans lequel le support de travail est une feuille de papier sans cendre.

FIG_1

FIG_2

FIG.3

Office européen des brevets

**RAPPORT DE RECHERCHE EUROPEENNE**

**0205380**
Numero de la demande

EP 86 40 1178

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int Cl 4) |
|---|---|---|---|
| A | FR-A-2 306 513 (R.T.C. LA RADIOTECHNIQUE-COMPELEC)<br>* Page 3, ligne 39 - page 4, ligne 22; page 8, ligne 27 - page 9, ligne 11; figure 4 * | 1,2,5 | H 01 G 1/035<br>H 01 G 4/30 |
| | --- | | |
| A | FR-A-2 087 614 (TRANCHANT ELECTRONIQUE SA)<br>* Page 1, ligne 25 - page 2, ligne 10; page 4, ligne 10 - page 5, ligne 34; page 6, lignes 28-33 * | 1,4-7, 9 | |
| | --- | | |
| A,D | FR-A-2 529 378 (EUROFARAD EFD)<br>* Revendications 1,9 * | 3,7 | |
| | --- | | |
| A | GB-A-1 144 196 (CORNING GLASS WORKS) | | |
| | ----- | | |

| | | | DOMAINES TECHNIQUES RECHERCHES (Int. Cl.4) |
|---|---|---|---|
| | | | H 01 G |

Le présent rapport de recherche a été etabli pour toutes les revendications

| Lieu de la recherche | Date d achèvement de la recherche | Examinateur |
|---|---|---|
| LA HAYE | 27-08-1986 | SCHUERMANS N.F.G. |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

OEB Form 1503 03 82